# EUROPEAN PATENT APPLICATION

(11) **EP 2 058 416 A2**
(43) Date of publication of application: **13.05.2009**
(21) Application number: 08019539.9
(22) Date of filing: 07.11.2008
(51) Int. Cl.: C23C 16/40, C23C 16/455

(54) **Preparation of a metal-containing film via ALD or CVD processes**

(30) Priority: 08.11.2007 US 986469 P; 21.10.2008 US 255128
(71) Applicant: Air Products and Chemicals, Inc., Allentown, PA 18195-1501 (US)
(72) Inventor: Kim, Min-Kyung, Suwon Gyeonggi (KR); Kim, Moo-Sung, Yongin-City Gyunggi-Do 446-920 (KR); Lei, Xinjian, Vista CA 92081 (US); Yang, San-Hyun, Suwon-City Gyunggi-Do 443-470 (KR)
(74) Representative: Kador & Partner

(57) **Abstract**

Methods for the deposition via chemical vapor deposition or atomic layer deposition of metal containing films, such as, for example, metal silicate or metal silicon oxynitride films are described herein. In one embodiment, the method for depositing a metal-containing film comprises the steps of introducing into a reaction chamber, a metal amide precursor, a silicon-containing precursor, and an oxygen source wherein each precursor is introduced after introducing a purge gas.

## Description

### CROSS-REFERENCE TO RELATED APPLICATIONS

This application claims benefit of U.S. Provisional Application No. 60/986,469, filed November 8, 2007. The disclosure of this provisional application is hereby incorporated by reference.

### BACKGROUND OF THE INVENTION

This present invention generally relates to a method for forming a metal containing film. More particularly, the present invention relates to a method for forming a metal-containing film, such as a metal silicate film or a metal silicon oxynitride film, using deposition processes such as, but not limited to, atomic layer deposition (ALD) or cyclic chemical vapor deposition (CCVD) that may be used, for example, as a gate dielectric or capacitor dielectric film in a semiconductor device.

With each generation of metal oxide semiconductor (MOS) integrated circuit (IC), the device dimensions have been continuously scaled down to provide for high-density and high-performance such as high speed and low power consumption requirements. Unfortunately, field effect semiconductor devices produce an output signal that is proportional to the width of the channel, such that scaling reduces their output. This effect has generally been compensated for by decreasing the thickness of gate dielectric, thus bring the gate in closer proximity to the channel and enhancing the field effect which thereby increasing the drive current. Therefore, it has become increasingly important to provide extremely thin reliable and low-defect gate dielectrics for improving device performance.

For decades, a thermal silicon oxide, SiO₂ has been mainly used as a gate dielectric because it is stable with the underlying silicon substrate and its fabrication process is relatively simple. However, because the silicon oxide gate dielectric has a low dielectric constant (k), 3.9, further scaling down of silicon oxide gate dielectric thickness has become more and more difficult, especially due to gate-to-channel leakage current through the thin silicon oxide gate dielectric.

This leads to consideration of alternative dielectric materials that can be formed in a thicker layer than silicon oxide but still produce the same or better device performance. This performance can be expressed as "equivalent oxide thickness (EOT)". Although the alternative dielectric material layer may be thicker than a comparative silicon oxide layer, it has the equivalent effect of a much thinner layer of silicon oxide layer.

To this end, high-k metal oxide materials have been proposed as the alternative dielectric materials for gate or capacitor dielectrics. Because the dielectric constant of metal oxide materials can be made greater than that of the silicon oxide, a thicker metal oxide layer having a similar EOT can be deposited.

Unfortunately, the use of high-k metal oxide materials presents several problems when using traditional substrate materials such as silicon. The silicon can react with the high-k metal oxide or be oxidized during deposition of the high-k metal oxide or subsequent thermal processes, thereby forming an interface layer of silicon oxide. This increases the equivalent oxide thickness, thereby degrading device performance. Further, an interface trap density between the high-k metal oxide layer and the silicon substrate is increased. Thus, the channel mobility of the carriers is reduced. This reduces the on/off current ratio of the MOS transistor, thereby degrading its switching characteristics. Also, the high-k metal oxide layer such as a hafnium oxide (HfO₂) layer or a zirconium oxide (ZrO₂) layer has a relatively low crystallization temperature and is thermally unstable. Thus, the metal oxide layer can be easily crystallized during a subsequent thermal annealing process for activating the impurities injected into source/drain regions. This can form grain boundaries in the metal oxide layer through which current can pass. As the surface roughness of the metal oxide layer increases, the leakage current characteristics may deteriorate. Further, the crystallization of the high-k metal oxide layer undesirably affects a subsequent alignment process due to irregular reflection of the light on an alignment key having the rough surface.

Accordingly, a need still remains for an improved dielectric layer structure with a higher crystallization temperature and the method of manufacturing the same to improve the device performance by reducing the equivalent oxide thickness of the dielectric layer as well as improvement of the interface characteristics.

### BRIEF SUMMARY OF THE INVENTION

Methods for depositing metal-containing films such as metal silicate films or metal silicon oxynitride films are described herein. In one embodiment, there is provided a method for forming a metal-containing film on at least one surface of a substrate is described herein and comprises the steps of: providing a substrate into a reactor; introducing into the reactor at least one metal amide precursor comprising the formula M(NR¹R²)ₖ wherein R¹ and R² are the same or different and are each independently selected from the group consisting of alkyl, vinyl, phenyl, cyclic alkyl, fluoroalkyl, and silylalkyl, and wherein k is a number ranging from 4 to 5; at least one silicon-containing precursor selected from the group consisting of a monoalkylaminosilane precursor comprising the formula (R³NH)ₙSiR⁴ₘH₄₋₍ₙ₊ₘ₎ wherein R³ and R⁴ are the same or different and are each independently selected from the group consisting of alkyl, vinyl, allyl, phenyl, cyclic alkyl, fluoroalkyl, silylalkyl and combinations thereof and wherein n is a number ranging from 1 to 3, m is a number ranging from 0 to 2, and the sum of "n+m" is a number that is equal to or less than 3 , a hydrazinosilane precursor comprising the formula (R⁵₂N-NH)ₓSiR⁶_{y}H_{4-(x+y)} wherein R⁵ and R⁶ are the same or different and each independently selected from the group consisting of alkyl, vinyl, allyl, phenyl, cyclic alkyl, fluoroalkyl, silylalkyl, and combinations thereof and wherein x is a number ranging from 1 to 2, y is a number ranging from 0 to 2, and the sum of "x+y" is a number equal to or less than 3, and a combination of the monoalkylaminosilane precursor and hydrazinosilane precursor and at least one oxygen source into the reactor wherein each precursor and source is introduced after introducing a purge gas; and exposing the at least one metal amide precursor, at least one silicon-containing precursor, and at least one oxygen source to one or more energy sources sufficient to react and provide the metal-containing film to form the metal-containing film on the at least one surface.

In a further embodiment of the method disclosed herein, the metal-containing film is deposited onto at least one surface of a substrate by: providing the at least one surface of the substrate; and forming the metal-containing film on the at least one surface by a deposition process chosen from a chemical vapor deposition process or an atomic layer deposition process from an at least one metal amide precursor comprising the formula M(NR¹R²)ₖ wherein R¹ and R² are the same or different and are each independently selected from the group consisting of alkyl, allyl, vinyl, phenyl, cyclic alkyl, fluoroalkyl, silylalkyl, and combinations thereof and wherein k is a number ranging from 4 to 5; an at least one silicon-containing precursor chosen from a monoalkylaminosilane precursor comprising the formula (R³NH)ₙSiR⁴ₘH₄₋₍ₙ₊ₘ₎, wherein R³ and R⁴ are the same or different and are each independently selected from an alkyl, allyl, vinyl, phenyl, cyclic alkyl, fluoroalkyl, silylalkyl group and combinations thereof and wherein n is a number ranging from 1 to 3, m is a number ranging from 0 to 2, and the sum of "n + m" is a number that is less than or equal to 3, and a hydrazinosilane precursor comprising the formula (R⁵₂N-NH)ₓSiR⁶_{y}H_{4-(x+y)} wherein R⁵ and R⁶ are same or different and each independently selected from the group consisting of alkyl, vinyl, allyl, phenyl, cyclic alkyl, fluoroalkyl, silylalkyl, and wherein x is a number ranging from 1 to 2, y is a number ranging from 0 to 2, and the sum of "x + y" is a number that is less than or equal to 3, and a combination of the monoalkylaminosilane precursor and the hydrazinosilane precursor; and at least one oxygen source.

In another embodiment of the method disclosed herein, the metal-containing film is formed using an ALD method that comprises the steps of: a). introducing a metal amide precursor in a vapor state into a reaction chamber and then chemisorbing the metal amide onto a substrate which is heated; b). purging away the unreacted metal amide; c). introducing an oxygen source gas into reaction chamber under plasma atmosphere to make a metal M-OH bond; d). purging away the unreacted oxygen source gas; e). introducing a silicon-containing precursor comprising monoalkylaminosilane or hydrazinosilane precursor in a vapor state into reaction chamber to make M-O-Si linkages; f). purging away the unreacted monoalkylaminosilane precursor; g). introducing the oxygen gas to the reaction chamber under a plasma atmosphere to make a Si -OH bond; and h). purging away the unreacted oxygen source gas. Also, in another embodiment, the metal amide precursor may be introduced after the monoalkylaminosilane or hydrazinosilane precursor precursor is introduced. In this embodiment, the steps may be performed in the order of e → f → g → h → a → b → c → d. In this or other embodiments, it is understood that the steps of the methods described herein may be performed in a variety of orders, may be performed sequentially or concurrently (e.g., during at least a portion of another step), and any combination thereof.

In yet another embodiment of the method disclosed herein, the metal-containing film is formed using a cyclic CVD method that comprises the steps of: a). introducing a metal amide in a vapor state into a reaction chamber under plasma atmosphere and then chemisorbing the metal amide onto a substrate which is heated; b). purging away the unreacted metal amide; c). introducing a silicon-containing precursor comprising monoalkylaminosilane or hydrazinosilane precursor in a vapor state into a reaction chamber under plasma atmosphere to make a bond between the metal amide adsorbed on the substrate and the monoalkylaminosilane or hydrazinosilane precursor; and d). purging away the unreacted monoalkylaminosilane precursor. The above steps are illustrative of one cycle of an embodiment of the method described herein; and the cycle can be repeated until the desired thickness of a metal-containing film is obtained. In this or other embodiments, it is understood that the steps of the methods described herein may be performed in a variety of orders, may be performed sequentially or concurrently (e.g., during at least a portion of another step), and any combination thereof.

### FIGURES

Figure 1 provides the thickness measured in Angstroms for four exemplary films deposited at various wafer temperatures.

Figure 2 provides the XPS data of the four exemplary films of Example 1, which indicate that the films contained Zr, Si and O.

Figure 3 provides the thickness measured in Angstroms for three exemplary films deposited at various wafer temperatures.

### DETAILED DESCRIPTION OF THE INVENTION

A method for making a metal-containing film such as a metal silicate film or a metal silicon oxynitride film which may be used, for example, in a semiconductor device structure is disclosed herein. Further uses for the metal silicate film or metal silicon oxynitride films include computer chips, optical device, magnetic information storage, to metallic catalyst coated on a supporting material. The method disclosed herein provides a metal-containing film that has a dielectric constant substantially higher than that of either conventional thermal silicon oxide or silicon nitride dielectric films so that the metal-containing film may be made having substantially greater thickness than the conventional dielectric films but with equivalent field effect. Examples of metal silicate films that can be deposited using the methods described herein may be, for example, zirconium silicate, cerium silicate, zinc silicate, thorium silicate, bismuth silicate, hafnium silicate, lanthanum silicate, tantalum silicate, or a combination or derivation of any of the aforementioned materials.

The method disclosed herein deposits the metal silicate or metal silicon oxynitride films using atomic layer deposition (ALD) or chemical vapor deposition (CVD) processes. Examples of suitable deposition processes for the method disclosed herein include, but are not limited to, cyclic CVD (CCVD), MOCVD (Metal Organic CVD), thermal chemical vapor deposition, plasma enhanced chemical vapor deposition ("PECVD"), high density PECVD, photon assisted CVD, plasma-photon assisted ("PPECVD"), cryogenic chemical vapor deposition, chemical assisted vapor deposition, hot-filament chemical vapor deposition, CVD of a liquid polymer precursor, deposition from supercritical fluids, and low energy CVD (LECVD). In certain embodiments, the metal silicate films are deposited via plasma enhanced ALD (PEALD) or plasma enhanced cyclic CVD (PECCVD) process. In these embodiments, the deposition temperature may be relatively lower, or may range from 200°C to 400°C, and may allow for a wider process window to control the specifications of film properties required in end-use applications. Exemplary deposition temperatures for the PEALD or PECCVD deposition include ranges having any one or more of the following endpoints: 200, 225, 250, 275, 300, 325, 350, 375, and/or 400°C.

In one embodiment of the method disclosed herein, a metal silicate or metal silicon oxynitride film is formed onto at least one surface of a substrate using a metal amide precursor, a silicon-containing precursor, and an oxygen source. Although metal amide and silicon-containing precursors typically react in either liquid form or gas phase thereby preventing film formation, the method disclosed herein avoids pre-reaction of the metal amide and silicon-containing precursors by using ALD or CCVD methods that separate the precursors prior to and/or during the introduction to the reactor. In this connection, deposition techniques such as an ALD or CCVD processes are used to deposit the metal-containing film. For example, in certain embodiments, an ALD process is used to deposit the metal-containing film. In a typical ALD process, the film is deposited by exposing the substrate surface alternatively to the metal amide or the silicon-containing precursors. Film growth proceeds by self-limiting control of surface reaction, the pulse length of each precursor, and the deposition temperature. However, once the surface of the substrate is saturated, the film growth ceases. In yet another embodiment, the metal-containing film may be deposited using a CCVD process. In this embodiment, the CCVD process may be performed using a higher temperature range than the ALD window, or from 350°C to 600°C thereby preventing, for example, precursor decomposition. Exemplary deposition temperatures for the CCVD deposition include ranges having any one or more of the following endpoints: 350, 375, 400, 425, 450, 475, 500, 525, 550, 575, and/or 600°C.

In a CCVD process, each precursor is sequentially introduced and separated whereas in a traditional CVD process all reactantive precursors are introduced to the reactor and induced to react with each other in gas phase.

As mentioned previously, the method disclosed herein forms the metal-containing films using at least one metal amide precursor, at least one silicon-containing precursor, and an oxygen source. Although the precursors and sources used herein may be sometimes described as "gaseous", it is understood that the precursors can be either liquid or solid which are transported with or without an innert gas into the reactor via direct vaporization, bubbling or sublimation. In some case, the vaporized precursors can pass through a plasma gernerator. Metals commonly used in semiconductor fabrication include that can be used as the metal component for the metal amide includes: titanium, tantalum, tungsten, hafnium, zirconium, cerium, zinc, thorium, bismuth, lanthanum, and combinations thereof. Examples of suitable metal amide precursors that may be used with the method disclosed herein include, but are not limited to, tetrakis(dimethylamino)zirconium (TDMAZ), tetrakis(diethylamino)zirconium (TDEAZ), tetrakis(ethylmethylamino)zirconium (TEMAZ), tetrakis(dimethylamino)hafnium (TDMAH), tetrakis(diethylamino)hafnium (TDEAH), and tetrakis(ethylmethylamino)hafnium (TEMAH), tetrakis(dimethylamino)titanium (TDMAT), tetrakis(diethylamino)titanium (TDEAT), tetrakis(ethylmethylamino)titanium (TEMAT), tert-butylimino tri(diethylamino)tantalum (TBTDET), tert-butylimino tri(dimethylamino)tantalum (TBTDMT), tert-butylimino tri(ethylmethylamino)tantalum (TBTEMT), ethylimino tri(diethylamino)tantalum (EITDET), ethylimino tri(dimethylamino)tantalum (EITDMT), ethylimino tri(ethylmethylamino)tantalum (EITEMT), tert-amylimino tri(dimethylamino)tantalum (TAIMAT), tert-amylimino tri(diethylamino)tantalum, pentakis(dimethylamino)tantalum, tert-amylimino tri(ethylmethylamino)tantalum, bis(tert-butylimino)bis(dimethylamino)tungsten (BTBMW), bis(tert-butylimino)bis(diethylamino)tungsten, bis(tert-butylimino)bis(ethylmethylamino)tungsten, and combinations thereof. In one embodiment, the metal amide precursor has the formula M(NR¹R²)ₖ, wherein R¹ and R² are the same or different and independently selected from the group consisting of alkyl, vinyl, phenyl, cyclic alkyl, fluoroalkyl, and silylalkyl and wherein k is a number ranging from 4 to 5. The term "alkyl" as used herein refers to optionally substituted, linear or branched hydrocarbon groups having from 1 to 20 carbon atoms, or from 1 to 10 carbon atoms, or from 1 to 6 carbon atoms.

The metal silicate film deposition further involves the introduction of at least one silicon-containing precursor. Examples of suitable silicon-containing precursors include a monoalkylaminosilane precursor, a hydrazinosilane precursor, or combinations thereof. In certain embodiments, the silicon-containing precursor comprises a monoalkylaminosilane precursor having at least one N-H fragment and at least one Si-H fragment. Suitable monoalkylaminosilane precursors containing both the N-H fragment and the Si-H fragment include, for example, bis(tert-butylamino)silane (BTBAS), tris(tert-butylamino)silane, bis(iso-propylamino)silane, tris(iso-propylamino)silane, and mixtures thereof. In one embodiment, the monoalkylaminosilane precursor has the formula (R³NH)ₙSiR⁴ₘH₄₋₍ₙ₊ₘ₎ wherein R³ and R⁴ are the same or different and independently selected from the group consisting of alkyl, vinyl allyl, phenyl, cyclic alkyl, fluoroalkyl, and silylalkyl and wherein n is a number ranging from 1 to 3, m is a number ranging from 0 to 2, and the sum of "n + m" is a number that is less than or equal to 3. In another embodiment, the silicon-containing precursor comprises a hydrazinosilane having the formula (R⁵₂N-NH)ₓSiR⁶_{y}H_{4-(x+y)} wherein R⁵ and R⁶ are same or different and independently selected from the group consisting of alkyl, vinyl, allyl, phenyl, cyclic alkyl, fluoroalkyl, silylalkyls and wherein x is a number ranging from 1 to 2, y is a number ranging from 0 to 2, and the sum of "x + y" is a number that is less than or equal to 3. Examples of suitable hydrazinosilane precursors include, but are not limited to, bis(1,1-dimethylhydrazino)-silane, tris(1,1-dimethylhydrazino)silane, bis(1,1-dimethylhydrazino)ethylsilane, bis(1,1-dimethylhydrazino)isopropylsilane, bis(1,1-dimethylhydrazino)vinylsilane, and mixtures thereof. Depending upon the deposition method, in certain embodiments, the silicon-containing precursor may be introduced into the reactor at a predetermined molar volume, or from about 0.1 to about 1000 micromoles. In this or other embodiments, the silicon-containing precursor may be introduced into the reactor for a predetermined time period, or from about 0.001 to about 500 seconds. The silicon-containing precursors react with the metal hydroxyl groups formed by the reaction of the metal amide with the oxygen source and become chemically adsorbed onto the surface of the substrate which results in the formation of a silicon oxide or a silicon oxynitride via metal-oxygen-silicon and metal-oxygen-nitrogen-silicon linkages, thus providing the metal silicate or the metal silicon oxynitride film.

As previously mentioned, the metal silicate or the metal silicon oxynitride films may be formed in the presence of oxygen. An oxygen source may be introduced into the reactor in the form of at least one oxygen source and/or may be present incidentally in the other precursors used in the deposition process. Suitable oxygen source gases may include, for example, water (H₂O) (e.g., deionized water, purifier water, and/or distilled water), oxygen (O₂), oxygen plasma, ozone (O₃), NO, NO₂, carbon monoxide (CO), carbon dioxide (CO₂) and combinations thereof. In certain embodiments, the oxygen source comprises an oxygen source gas that is introduced into the reactor at a flow rate ranging from about 1 to about 2000 square cubic centimeters (sccm) or from about 1 to about 1000 sccm. The oxygen source can be introduced for a time that ranges from about 0.1 to about 100 seconds. In one particular embodiment, the oxygen source comprises water having a temperature of 10°C or greater. In this or other embodiments wherein the film is deposited by an ALD process, the precursor pulse can have a pulse duration that is greater than 0.01 seconds, and the oxidant pulse duration can have a pulse duration that is greater than 0.01 seconds, while the water pulse duration can have a pulse duration that is greater than 0.01 seconds. In yet another embodiment, the purge duration between the pulses that can be as low as 0 seconds.

The deposition methods disclosed herein may involve one or more purge gases. The purge gas, which is used to purge away unconsumed reactants and/or reaction byproducts, is an inert gas that does not react with the precursors and may preferably be selected from the group consisting of Ar, N₂, He, H₂ and mixture thereof. In certain embodiments, a purge gas such as Ar is supplied into the reactor at a flow rate ranging from about 10 to about 2000 sccm for about 0.1 to 1000 seconds, thereby purging the unreacted material and any byproduct that remain in the reactor.

In certain embodiments, such as for those embodiments where a metal silicon oxynitride film is deposited, an additional gas such as a nitrogen source gas may be introduced into the reactor. Examples of nitrogen source gases may include, for example, NO, NO₂, ammonia, hydrazine, monoalkylhydrazine, dialkylhydrazine, and combinations thereof.

In one embodiment of the method described herein, the temperature of the substrate in the reactor, i.e., a deposition chamber, is about 600°C or below or about 500 °C or below. In this or other embodiments, the pressure may range from about 0.1 Torr to about 100 Torr or from about 0.1 Torr to about 5 Torr.

The respective step of supplying the precursors, the oxygen source, and/or other precursors or source gases may be performed by changing the time for supplying them to change the stoichiometric composition of the resulting metal silicate or metal silicon oxynitride film.

Energy is applied to the precursor, source, or combination thereof to induce reaction and to form the metal-containing film on the substrate. Such energy can be provided by, but not limited to, thermal, plasma, pulsed plasma, helicon plasma, high density plasma, inductively coupled plasma, X-ray, e-beam, photon, and remote plasma methods. In certain embodiments, a secondary RF frequency source can be used to modify the plasma characteristics at the substrate surface. In embodiments wherein the deposition involves plasma, the plasma-generated process may comprise a direct plasma-generated process in which plasma is directly generated in the reactor, or alternatively a remote plasma-generated process in which plasma is generated outside of the reactor and supplied into the reactor.

In one embodiment of the method described herein, a plasma enhanced cyclic deposition is employed using tetrakis(ethylmethylamino)zirconium or (TEMAZ) or tetrakis(ethylmethylamino)hafnium (TEMAH), bis(tert-butylamino)silane (BTBAS), and oxygen as the metal amide precursor, silicon-containing precursor and oxygen source gas, respectively. In this embodiment, the gas lines connecting the precursor canisters to the reaction chamber are heated to a range of from 70 to 120°C for TEMAZ and/or TEMAH, and the container of TEMAZ/TEMAH is kept in the temperature of 60 to 105°C. The silicon-containing precursor BTBAS can be kept at room temperature as it has sufficient vapor pressure. The delivery type of precursor to the reaction chamber is a bubbling in which 10∼50sccm of argon gas carries the vapor of metal amide precursors to reaction chamber during the precursor pulsing. A 250∼1000sccm flow of argon gas was continuously used during the process, and the reaction chamber process pressure is maintained in the range of 0.1 to 5 Torr. A silicon oxide wafer is used as a substrate, the thickness of which is more than 1000Å to completely isolate interference of a sub-silicon layer on the measurement of sheet resistance of the film. During this embodiment, the silicon oxide wafer is heated on a heater stage in reaction chamber and is exposed to the TEMAZ or TEMAH initially and then the TEMAZ or TEMAH precursor adsorbs onto the surface of silicon oxide wafer. Argon gas purges away unabsorbed excess TEMAZ or TEMAH from the process chamber. After enough Ar purging, oxygen gas is introduced into reaction chamber whereby plasma is directly generated inside a chamber. Activated oxygen by plasma replaces the ethylmethylamino ligands of TEMAZ or TEMAH adsorbed on the substrate and forms a bond between Zr or Hf and hydroxyl. Ar gas which follows then purges away unreacted excess O₂ from the chamber. Thereafter, BTBAS is introduced into the chamber and contributes to the bonding formation of Zr(Hf)-O-Si and Zr(Hf)-O-N-Si via reaction of BTBAS with Zr(Hf) hydroxyl. Unabsorbed excess BTBAS molecules are purged away by the following Ar purge gas. Oxygen gas is introduced into the chamber in plasma-generated condition and replaces the ligands of BTBAS to form the Si-O bond. The surface treated by oxygen gas provides new reaction sites for the following TEMAZ or TEMAH introduction. Unreacted excess oxygen gas is purged away by Ar gas. The aforementioned steps define the typical cycle for the present three-chemical process. However, other chemicals besides those described herein may be also added. The process cycle can be repeated several times to achieve the desired film thickness.

Metal-containing films such as Zr(Hf)SiOx or Zr(Hf) SiNOx films may be used as an insulating material in memory and logic devices and require various specifications of film properties such as high-k , thermal stability in crystallinity, material compatibility with adjacent layers, and so on. Certain process parameters such as, for example, deposition temperature, precursor pulsing time, and/or RF power can be adjusted to provide desired film properties. For example, for methods related to the deposition of Zr(Hf)SiOx or Zr(Hf) SiNO films, the film composition (Zr(Hf)/Si At.% Ratio) is dependent upon the quantity of TEMAZ or TEMAH and BTBAS supplied into the process chamber. In one embodiment, the quantity of TEMAZ(TEMAH) and BTBAS can be adjusted by changing the pulsing time of each precursor and the temperature of the canister of precursors.

In one embodiment of the method disclosed herein, the metal-containing film is formed using an ALD method that comprises the steps of: a. introducing a metal amide precursor in a vapor state into a reaction chamber and then chemisorbing the metal amide onto a substrate which is heated; b. purging away the unreacted metal amide; c. introducing an oxygen source gas into reaction chamber under plasma atmosphere to make a metal M-OH bond; d. purging away the unreacted oxygen source gas; e. introducing a silicon-containing precursor comprising monoalkylaminosilane in a vapor state into reaction chamber to make M-O-Si linkages; f. purging away the unreacted monoalkylaminosilane precursor; g. introducing the oxygen gas to reaction chamber under plasma atmosphere to make Si -OH bond; and h. purging away the unreacted oxygen source gas. Also, in another embodiment, the metal amide precursor may be introduced after the monoalkylaminosilane precursor is introduced. In this embodiment, the steps may be performed in the order of e → f → g → h → a → b → c → d. In this or other embodiments, it is understood that the steps of the methods described herein may be performed in a variety of orders, may be performed sequentially or concurrently (e.g., during at least a portion of another step), and any combination thereof.

In yet another embodiment of the method disclosed herein, the metal-containing film is formed using a cyclic CVD method that comprises the steps of: a. introducing a metal amide in a vapor state into a reaction chamber under plasma atmosphere and then chemisorbing the metal amide onto a substrate which is heated; b. purging away the unreacted metal amide; c. introducing a silicon-containing precursor comprising monoalkylaminosilane precursor in a vapor state into a reaction chamber under plasma atmosphere to make a bond between the metal amide adsorbed on the substrate and the monoalkylaminosilane precursor; d. purging away the unreacted monoalkylaminosilane precursor. The above steps define one cycle for the present method; and the cycle can be repeated until the desired thickness of a metal-containing film is obtained. In this or other embodiments, it is understood that the steps of the methods described herein may be performed in a variety of orders, may be performed sequentially or concurrently (e.g., during at least a portion of another step), and any combination thereof.

As mentioned previously, the method described herein may be used to deposit a metal-containing film on at least a portion of a substrate. Examples of suitable substrates include but are not limited to, semiconductor materials such as gallium arsenide ("GaAs"), boronitride ("BN") silicon, and compositions containing silicon such as crystalline silicon, polysilicon, amorphous silicon, epitaxial silicon, silicon dioxide ("SiO₂"), silicon carbide ("SiC"), silicon oxycarbide ("SiOC"), silicon nitride ("SiN"), silicon carbonitride ("SiCN"), organosilicate glasses ("OSG"), organofluorosilicate glasses ("OFSG"), fluorosilicate glasses ("FSG"), and other appropriate substrates or mixtures thereof. Substrates may further comprise a variety of layers to which the film can be applied thereto such as, for example, antireflective coatings, photoresists, organic polymers, porous organic and inorganic materials, metals such as copper and aluminum, or diffusion barrier layers.

The metal silicate film formed by the method described herein may be titanium silicate, tantalum silicate, tungsten silicate, hafnium silicate, zirconium-hafnium silicate, zirconium silicate, or laminates thereof. In embodiments wherein the metal silicate film is a laminate, the term "laminate" as used herein means a film or material having two or more layers which can be the same material or different materials and can comprise intervening materials or films that may or may not be metal silicate films or materials. In one particular embodiment, the metal-containing film comprises a nanolaminate comprising silicon oxide and hafnium oxide. In another embodiment, the metal-containing film comprises a nanolaminate comprising silicon oxide and zirconium oxide. In a further embodiment, the metal-containing film comprises a nanolaminate comprising silicon oxide, zirconium oxide, and hafnium oxide. Still further examples of the metal-containing films deposited herein may be metal silicates, metal oxides, silicon oxides, metal silicon oxynitride films and laminates, and/or combinations thereof. Typical thicknesses for the metal-containing film may range from 10Å to 100Å or from 100Å to 500Å. The dielectric constant of the metal-containing film formed herein may range from 7 to 40.

The following examples illustrate the method for preparing a metal-containing film described herein are not intended to limit it in any way.

### Examples

### Example 1. Preparation of zirconium silicate films by PEALD at various temperatures

Exemplary zirconium silicate films were deposited in a shower-head type ALD reactor made by Quros Co. of South Korea. The temperature of the wafer was controlled using a proportional integral derivative (PID) controller. The films were deposited onto silicon wafers, which were boron-doped p-type (100) wafers having a resistivity of from 1 - 50 Ohm·cm, produced by LG Siltron of South Korea. The metal amide precursor used in the deposition was tetrakis(ethylmethylamino)zirconium (TEMAZ), which was housed in a temperature-controlled bubbler model BK 500 UST manufactured by Air Products and Chemicals, Inc. of Allentown, PA and delivered using argon as a carrier gas. The silicon-containing precursor used in the deposition was bis(tert-butylamino)silane (BTBAS) which was housed in a temperature-controlled bubbler model BK1200USH manufactured by Air Products and Chemicals, Inc. of Allentown, PA and delivered using argon as a carrier gas. The oxygen source was an oxygen plasma that was ignited using a rf generator using the following conditions: O₂ flow rate of 100 sccm and RF power of 50 W. The reactor pressure was approximately 1 Torr and RF power were held constant throughout each ALD cycle. Deposition occurred on Si wafers clamped to the grounded electrode that was resistively heated to one of the following temperatures: 200°C, 250°C, 300°C, and 350°C. A continuous flow of argon at a flow rate of 500 standard cubic centimeters (sccm) (which was 250 sccm at the precursor side and 250 sccm at the oxygen source side) was flowing throughout the whole deposition. A typical ALD cycle was comprised of sequential supplies of the silicon-containing precursor BTBAS bubbled by an Ar carrier gas at a flow rate of 25 sccm for 0.5 seconds; 5 seconds for an Ar purge; an oxygen plasma at a flow rate of 100 sccm for 5 seconds during RF plasma generation; 5 seconds for an Ar purge gas; the metal amide precursor TEMAZ bubbled by an Ar carrier gas at a flow rate of 25 sccm for 3 seconds; 5 seconds for an Ar purge; and an oxygen plasma gas at a flow rate of 100 sccm for 5 seconds during RF plasma generation; and 5 seconds for an Ar purge. The process chamber or reactor pressure was about 1.0 Torr. The cycle was repeated approximately 200 times at differing wafer temperatures of 200, 250, 300, 350°C for each exemplary film.

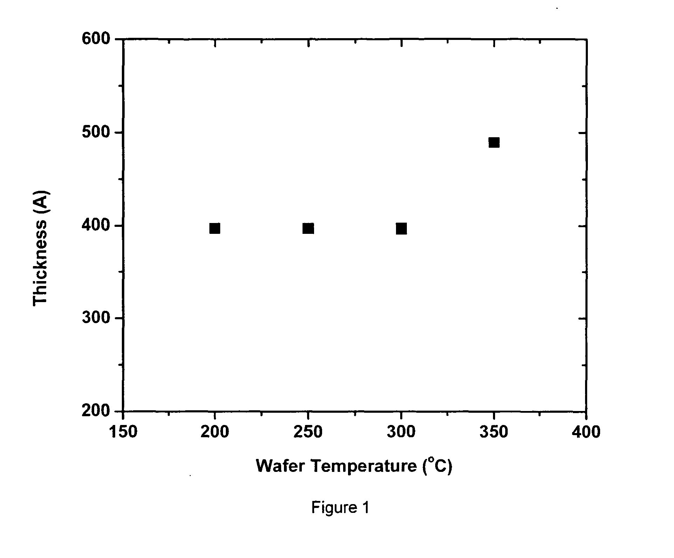

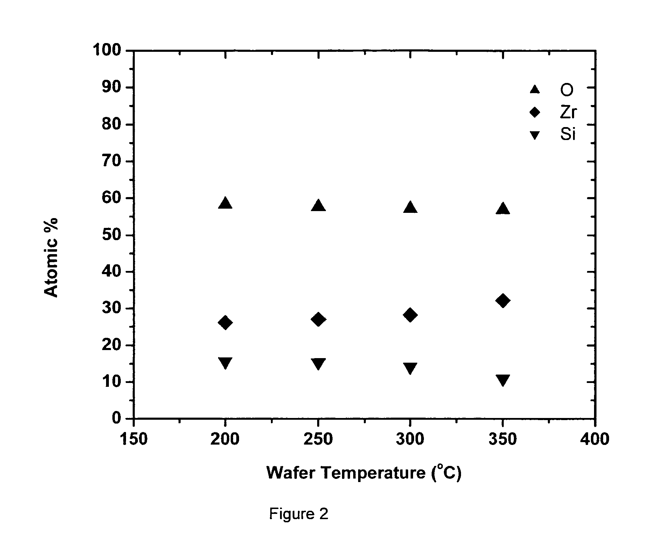

Film thicknesses of each exemplary film were measured in angstroms by spectroscopic ellipsometry using a model SE 800 spectroscopic ellipsometer manufactured by Sentech Instruments. Figure 1 provides the comparison of film thickness versus temperature for the PEALD for the four deposited ZrSiOx films. X-Ray photoelectron spectroscopy (XPS) was also performed to determine the chemical composition of the deposited films. Figure 2 provides the XPS data of the films from Example 1, which indicates that the resulting films did contain Zr, Si and O.

### Example 2. Preparation of zirconium silicate films at 250°C by PEALD

Except for the heater temperature being 250°C, three exemplary films were deposited in the same manner as described in Example 1. Wafer temperatures are 200°C, 250°C, 300°C, and 350°C. The temperature difference between wafer temperature and heater temperature was varied with heater temperature.

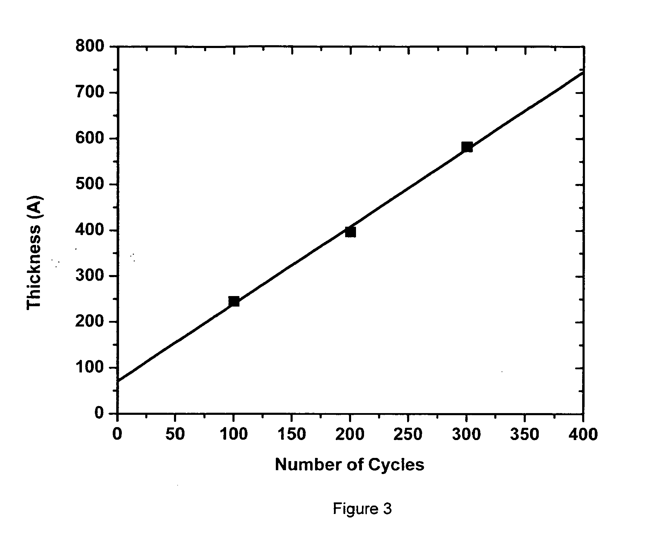

Figure 3 illustrate the results of the above test. Film thicknesses of each exemplary film that was deposited at the various temperatures were measured in angstroms by spectroscopic ellipsometry using a model SE 800 spectroscopic ellipsometer manufactured by Sentech Instruments. Figure 3 provides the comparison of film thickness versus temperature for the PEALD process for the three deposited ZrSiOx films.

### Example 3. Prophetic Example for the Preparation of Zirconium oxide and Silicon oxide nanolaminate films at 250°C by PEALD

Nanolaminate films comprising zirconium oxide and silicon oxide can be prepared in the following manner. Process chamber pressure is about 1.0 Torr, first of all, 200 cycles of ZrO₂ were deposited with the following cycle: TEMAZ is bubbled by an Ar carrier gas at a flow rate of 25 sccm for 3 seconds; an Ar purge gas at a flow rate of 500 sccm for 5 seconds; oxygen plasma gas at a flow rate of 100 sccm for 5 seconds during RF plasma generation; and an Ar purge gas at a flow rate of 500 sccm for 5 seconds. Secondly, 50 cycles of SiO₂ is deposited with the following cycle: BTBAS is bubbled by an Ar carrier gas at a flow rate of 25 sccm for 0.5 seconds; an Ar purge gas at a flow rate of 500 sccm for 5 seconds; oxygen plasma at a flow rate of 100 sccm for 5 seconds during RF plasma generation; and an Ar purge gas at a flow rate of 500 sccm for 5 seconds. Then another 200 cycles ZrO₂ is deposited to provide the zirconium oxide/silicon oxide/zirconium oxide nanolaminate film.

### Example 4. Prophetic Example for the Preparation of Hafnium Silicate films by PEALD at various temperatures

Hafnium silicate films can be prepared using the same experimental conditions as provided in Example 1 with the exception that the metal amide precursor is tetrakis(ethylmethylamino)hafnium (TEMAH) rather than TEMAZ.

### Example 5. Prophetic Example for the Preparation of Hafnium silicate films at 250°C by PEALD

Hafnium silicate films can be prepared using the same experimental conditions as provided in Example 2 with the exception that the metal amide precursor is tetrakis(ethylmethylamino)hafnium (TEMAH) rather than TEMAZ.

### CLAUSES

In the following clauses, preferred embodiments of the invention are described:
1. A method for forming a metal-containing film on at least one surface of a substrate, the method comprising:
   providing a substrate within a reactor;
   introducing into the reactor
   at least one metal amide precursor comprising the formula M(NR¹R²)ₖ wherein R¹ and R² are the same or different and are each independently selected from the group consisting of alkyl, allyl, vinyl, phenyl, cyclic alkyl, fluoroalkyl, silylalkyl, and combinations thereof and wherein k is a number ranging from 4 to 5;
   at least one silicon-containing precursor chosen from
      a monoalkylaminosilane precursor comprising the formula (R³NH) ₙSiR⁴ₘH_{4-*n+m)}, wherein R³ and R⁴ are the same or different and are each independently selected from an alkyl, allyl, vinyl, phenyl, cyclic alkyl, fluoroalkyl, silylalkyl group and combinations thereof and wherein n is a number ranging from 1 to 3, m is a number ranging from 0 to 2, and the sum of "n + m" is a number that is equal to or less than 3, and
      a hydrazinosilane precursor comprising the formula (R⁵₂N-NH)ₓSiR⁶_{y}H_{4-(x+y)} wherein R⁵ and R⁶ are same or different and each independently selected from the group consisting of alkyl, vinyl, allyl, phenyl, cyclic alkyl, fluoroalkyl, silylalkyl, and wherein x is a number ranging from 1 to 2, y is a number ranging from 0 to 2, and the sum of "x + y" is a number that is equal to or less than 3,
      and a combination of the monoalkylaminosilane precursor and the hydrazinosilane precursor; and
   at least one oxygen source wherein each precursor and source is introduced after introducing a purge gas;
   and exposing the at least one metal amide precursor, at least one silicon-containing precursor, and at least one oxygen source to one or more energy sources sufficient to react and provide the metal-containing film on the at least one surface of the substrate.
2. The method of clause 1, wherein the substrate comprises a silicon wafer.
3. The method of clause 1, wherein the metal amide compound is selected from the group consisting of tetrakis(dimethylamino)zirconium (TDMAZ), tetrakis(diethylamino)zirconium (TDEAZ), tetrakis(ethylmethylamino)zirconium (TEMAZ), tetrakis(dimethylamino)hafnium (TDMAH), tetrakis(diethylamino)hafnium (TDEAH), tetrakis(ethylmethylamino)hafnium (TEMAH), tetrakis(dimethylamino)titanium (TDMAT), tetrakis(diethylamino)titanium (TDEAT), tetrakis(ethylmethylamino)titanium (TEMAT), tert-Butylimino tri(diethylamino)tantalum (TBTDET), tert-butylimino tri(dimethylamino)tantalum (TBTDMT), tert-butylimino tri(ethylmethylamino)tantalum (TBTEMT), ethylimino tri(diethylamino)tantalum (EITDET), ethylimino tri(dimethylamino)tantalum (EITDMT), ethylimino tri(ethylmethylamino)tantalum (EITEMT), tert-amylimino tri(dimethylamino)tantalum (TAIMAT), tert-amylimino tri(diethylamino)tantalum, pentakis(dimethylamino)tantalum, tert-amylimino tri(ethylmethylamino)tantalum, bis(tert-butylimino)bis(dimethylamino)tungsten (BTBMW), bis(tert-butylimino)bis(diethylamino)tungsten, bis(tert-butylimino)bis(ethylmethylamino)tungsten, and combinations thereof.
4. The method of clause 1, wherein the silicon-containing precursors comprises a monoalkylaminosilane compound selected from the group consisting of bis(tert-butylamino)silane (BTBAS), tris(tert-butylamino)silane, bis(iso-propylamino)silane, tris(iso-propylamino)silane, and combinations thereof.
5. The method of clause 1, wherein the silicon-containing precursors comprises a hydrazinosilane compound selected from the group consisting of bis(1,1-dimethylhydrazino)silane, tris(1,1-dimethylhydrazino)silane, bis(1,1-dimethylhydrazino)ethylsilane, bis(1,1-dimethylhydrazino)isopropylsilane, and bis(1,1-dimethylhydrazino)vinylsilane, and combinations thereof.
6. The method of clause 1, wherein the oxygen source is chosen from H₂O, oxygen, oxygen plasma, water plasma, ozone, and combinations thereof.
7. The method of clause 1, wherein the purge gas comprises at least one selected from the group consisting of Ar, N₂, He, H₂, and combinations thereof.
8. The method of clause 1, wherein the forming is a cyclic chemical vapor deposition process.
9. The method of clause 1, wherein the forming is an atomic layer deposition process.
10. The method of clause 1, wherein the forming is conducted at a temperature of 500°C or below.
11. The method of clause 1, wherein the forming is a thermal deposition process.
12. The method of clause 1, wherein the forming is a plasma-enhanced deposition process.
13. The method of clause 13, wherein the plasma-enhanced deposition is a direct plasma-generated process.
14. The method of clause 13, wherein the plasma-enhanced deposition is a remote plasma-generated process.
15. A metal-containing film made by the method of clause 1.
16. The metal-containing film of clause 15 wherein the thicknesses ranges from 5 to 100 Angstroms.
17. The metal-containing film of clause 15 comprising hafnium silicate or a laminate thereof.
18. The metal-containing film of clause 15 comprising zirconium silicate or a laminate thereof.
19. The metal-containing film of clause 15 comprisng a nanolaminate comprising hafnium oxide and silicon oxide.
20. The metal-containing film of clause 15 comprising a nanolaminate comprising zirconium oxide and silicon oxide.
21. The metal-containing film of clause 15 comprising a nanolaminate comprising hafnium oxide, zirconium oxide, and silicon oxide.
22. A method for forming a metal-containing film on at least one surface of a substrate, the method comprising:
   providing the at least one surface of the substrate; and
   forming the metal-containing film on the at least one surface by a deposition process chosen from a chemical vapor deposition process and an atomic layer deposition process from an at least one metal amide precursor comprising the formula M(NR¹R²)ₖ wherein R¹ and R² are the same or different and are each independently selected from the group consisting of alkyl, allyl, vinyl, phenyl, cyclic alkyl, fluoroalkyl, silylalkyl, and combinations thereof and wherein k is a number ranging from 4 to 5; an at least one silicon-containing precursor chosen from a monoalkylaminosilane precursor comprising the formula (R³NH) ₙSiR⁴ₘH₄₋₍ₙ₊ₘ₎, wherein R³ and R⁴ are the same or different and are each independently selected from an alkyl, allyl, vinyl, phenyl, cyclic alkyl, fluoroalkyl, silylalkyl group and combinations thereof and wherein n is a number ranging from 1 to 3, m is a number ranging from 0 to 2, and the sum of "n + m" is a number that is less than or equal to 3, a hydrazinosilane precursor comprising the formula (R⁵₂N-NH)ₓSiR⁶_{y}H_{4-(x+y)} wherein R⁵ and R⁶ are same or different and each independently selected from the group consisting of alkyl, vinyl, allyl, phenyl, cyclic alkyl, fluoroalkyl, silylalkyl, and wherein x is a number ranging from 1 to 2, y is a number ranging from 0 to 2, and the sum of "x + y" is a number that is less than or equal to 3, and a combination of the monoalkylaminosilane precursor and the hydrazinosilane precursor; and at least one oxygen source.

## Claims

1. A method for forming a metal-containing film on at least one surface of a substrate, the method comprising:
providing the at least one surface of the substrate; and
forming the metal-containing film on the at least one surface by a deposition process chosen from a chemical vapor deposition process and an atomic layer deposition process from an at least one metal amide precursor comprising the formula M(NR¹R²)ₖ wherein R¹ and R² are the same or different and are each independently selected from the group consisting of alkyl, allyl, vinyl, phenyl, cyclic alkyl, fluoroalkyl, silylalkyl, and combinations thereof and wherein k is a number ranging from 4 to 5; an at least one silicon-containing precursor chosen from a monoalkylaminosilane precursor comprising the formula (R³NH)ₙSiR⁴ₘH₄₋₍ₙ₊ₘ₎, wherein R³ and R⁴ are the same or different and are each independently selected from an alkyl, allyl, vinyl, phenyl, cyclic alkyl, fluoroalkyl, silylalkyl group and combinations thereof and wherein n is a number ranging from 1 to 3, m is a number ranging from 0 to 2, and the sum of "n + m" is a number that is less than or equal to 3, a hydrazinosilane precursor comprising the formula (R⁵₂N-NH)ₓSiR⁶_{y}H_{4-(x+y)} wherein R⁵ and R⁶ are same or different and each independently selected from the group consisting of alkyl, vinyl, allyl, phenyl, cyclic alkyl, fluoroalkyl, silylalkyl, and wherein x is a number ranging from 1 to 2, y is a number ranging from 0 to 2, and the sum of "x + y' is a number that is less than or equal to 3, and a combination of the monoalkylaminosilane precursor and the hydrazinosilane precursor; and at least one oxygen source.

2. The method of claim 1, wherein the metal amide compound is selected from the group consisting of tetrakis(dimethylamino)zirconium (TDMAZ), tetrakis(diethylamino)zirconium (TDEAZ), tetrakis(ethylmethylamino)zirconium (TEMAZ), tetrakis(dimethylamino)hafnium (TDMAH), tetrakis(diethylamino)hafnium (TDEAH), tetrakis(ethylmethylamino)hafnium (TEMAH), tetrakis(dimethylamino)titanium (TDMAT), tetrakis(diethylamino)titanium (TDEAT), tetrakis(ethylmethylamino)titanium (TEMAT), tert-Butylimino tri(diethylamino)tantalum (TBTDET), tert-butylimino tri(dimethylamino)tantalum (TBTDMT), tert-butylimino tri(ethylmethylamino)tantalum (TBTEMT), ethylimino tri(diethylamino)tantalum (EITDET), ethylimino tri(dimethylamino)tantalum (EITDMT), ethylimino tri(ethylmethylamino)tantalum (EITEMT), tert-amylimino tri(dimethylamino)tantalum (TAIMAT), tert-amylimino tri(diethylamino)tantalum, pentakis(dimethylamino)tantalum, tert-amylimino tri(ethylmethylamino)tantalum, bis(tert-butylimino)bis(dimethylamino)tungsten (BTBMW), bis(tert-butylimino)bis(diethylamino)tungsten, bis(tert-butylimino)bis(ethylmethylamino)tungsten, and combinations thereof.

3. The method of claim 1, wherein the silicon-containing precursors comprises a monoalkylaminosilane compound selected from the group consisting of bis(tert-butylamino)silane (BTBAS), tris(tert-butylamino)silane, bis(iso-propylamino)silane, tris(iso-propylamino)silane, and combinations thereof.

4. The method of claim 1, wherein the silicon-containing precursors comprises a hydrazinosilane compound selected from the group consisting of bis(1,1-dimethylhydrazino)silane, tris(1,1-dimethylhydrazino)silane, bis(1,1-dimethylhydrazino)ethylsilane, bis(1,1-dimethylhydrazino)isopropylsilane, and bis(1,1-dimethylhydrazino)vinylsilane, and combinations thereof.

5. The method of claim 1, wherein the oxygen source is chosen from H₂O, oxygen, oxygen plasma, water plasma, ozone, and combinations thereof.

6. The method of claim 1, wherein the purge gas comprises at least one selected from the group consisting of Ar, N₂, He, H₂, and combinations thereof.

7. The method of claim 1, wherein the forming is the chemical vapor deposition process.

8. The method of claim 1, wherein the forming is an atomic layer deposition process.

9. The method of claim 1, wherein the forming is conducted at a temperature of 500°C or below.

10. The method of claim 1, wherein the forming is a thermal deposition process.

11. The method of claim 1, wherein the forming is a plasma-enhanced deposition process.

12. The method of claim 11 wherein the plasma-enhanced deposition is at least one selected from a direct plasma-generated process, a remote plasma-generated process, and combinations thereof.

13. A metal-containing film made by the method of claim 1.

14. The metal-containing film of claim 15 wherein the thicknesses ranges from 5 to 100 Angstroms.

15. The metal-containing film of claim 15 comprising at least one selected from a hafnium oxide, a hafnium silicate, a zirconium oxide, a zirconium silicate, a silicon oxide, and a laminate thereof.
